# FASCICULE DE BREVET EUROPEEN

(11) **EP 1 206 729 B1**
(45) Date de publication et mention de la délivrance du brevet: **17.08.2005**
(21) Numéro de dépôt: 99957326.4
(22) Date de dépôt: 26.11.1999
(51) Int. Cl.: G04G 1/00

(54) **SYSTEME DE MISE A L'HEURE AUTOMATIQUE D'UN OBJET PORTATIF AYANT UNE FONCTION HORLOGERE**
SYSTEM DER AUTOMATISCHEN ZEITEINSTELLUNG EINES TRAGBAREN GEGENSTANDES MIT EINER UHRENFUNKTION
SYSTEM FOR AUTOMATICALLY SETTING A PORTABLE OBJECT WITH A CLOCK FUNCTION

(30) Priorité: 03.08.1999 EP 99115319
(43) Date de publication de la demande: 22.05.2002
(73) Titulaire: ETA SA Manufacture Horlogère Suisse, 2540 Grenchen (CH)
(72) Inventeur: FLEURY, Emmanuel, CH-2740 Moutier (CH); BLONDEAU, Fabien, CH-2525 Le Landeron (CH); BARRAS, David, CH-2540 Grenchen (CH); MEISTER, Pierre-André, CH-2502 Bienne (CH)
(74) Mandataire: Ravenel, Thierry Gérard Louis
(86) Numéro de dépôt international: PCT/EP1999/009218
(87) Numéro de publication internationale: WO 2001/009689

(56) Documents cités:
- US-A- 4 020 628
- US-A- 4 204 398
- US-A- 4 242 745

## Description

La présente invention concerne généralement un système de mise à l'heure automatique d'un objet portatif ayant une fonction horlogère. La présente invention concerne également un objet portatif ayant une fonction horlogère, telle une pièce d'horlogerie électronique, susceptible d'être mis à l'heure automatiquement.

Au sens de la présente invention, on entendra par "objet portatif ayant une fonction horlogère" tout objet de petites dimensions tel que, de manière préférée mais non limitative, une pièce d'horlogerie électronique, susceptible de traiter et d'afficher au moins une première indication horaire, telle l'heure et/ou la date.

On connaît déjà des montres ou horloges électroniques susceptibles d'être mises à l'heure automatiquement par l'intermédiaire d'un signal horaire radiodiffusé émis par un observatoire ou un institut du temps. On connaît de tels objets sous la dénomination montre ou horloge "radiosynchronisée" ou par les termes équivalents montre °radiocommandée° ou "radiopilotée".

Le brevet américain no. 4,315,332 décrit par exemple une pièce d'horlogerie comprenant un récepteur radio agencé pour recevoir et décoder un signal horaire radiodiffusé ainsi que des moyens de correction répondant au dit signal horaire pour corriger l'heure affichée par la pièce d'horlogerie.

Le document US-A-4 242 745, qui peut être considéré comme définissant l'état de la technique le plus proche, décrit notamment une pièce d'horlogerie. électronique comprenant un transducteur électroacoustique pour recevoir des signaux acoustiques permettant la mise à l'heure automatique de la pièce d'horlogerie. Ce transducteur électroacoustique est également utilisé pour produire une alarme.

Un désavantage de telles pièces d'horlogeries, et d'autres objets portatifs ayant une fonction horlogère et faisant appel à un signal de mise à l'heure radiodiffusé, réside, dans le fait que la pièce d'horlogerie, ou plus généralement l'objet portatif ayant une fonction horlogère, doit nécessairement comprendre des moyens de réception du signal radiodiffusé. Ces moyens de réception comprennent typiquement une antenne de réception radio ajustée, ou susceptible d'être ajustée, à la fréquence de transmission du signal horaire radiodiffusé. Ces moyens de réception ne sont communément pas présents dans une pièce d'horlogerie électronique conventionnelle et sont par ailleurs typiquement caractérisés par un coût de revient relativement élevé qui se répercute sur les coûts de fabrication de l'objet portatif.

Un autre désavantage de tels objets portatifs réside dans le fait que la mise à l'heure de tels objets portatifs nécessite l'accord de l'objet portatif à la fréquence d'émission du signal horaire radiodiffusé. En particulier, cette fréquence d'émission du signal horaire peut varier d'une région ou d'un pays à l'autre. A titre d'exemple, l'émetteur de Prangins, en Suisse, connu sous l'immatriculation HBG, transmet un signal horaire radiodiffusé à une fréquence de 75 kHz, l'émetteur de Mainflingen, en Allemagne, connu sous l'immatriculation DCF77, transmet ce signal horaire radiodiffusé à une fréquence de 77,5 kHz et l'émetteur de Rugby, en Grande-Bretagne, connu sous l'immatriculation MSF, transmet ce signal horaire radiodiffusé à une fréquence de 60 kHz. En conséquence, afin d'assurer un fonctionnement adéquat de tels objets portatifs radiosynchronisés, il est nécessaire de les équiper de moyens additionnels permettant l'ajustement de la fréquence de réception du signal horaire radiodiffusé selon le lieu ou se trouve l'utilisateur. Ces moyens additionnels augmentent encore les coûts de fabrication et la complexité de ces objets portatifs.

Un premier but de la présente invention est ainsi de proposer une solution permettant la mise à l'heure automatique d'un objet portatif ayant une fonction horlogère qui pallie aux inconvénients susmentionnés.

En particulier, un but de la présente invention est de proposer une solution permettant la mise à l'heure automatique d'un objet portatif ayant une fonction horlogère qui ne fait préférablement appel qu'à des moyens dont est déjà équipé ledit objet portatif ou qui ne nécessite qu'une adaptation aussi minime que possible de l'électronique de l'objet portatif.

A cet effet, la présente invention a pour objet un système permettant la mise à l'heure automatique d'un objet portatif ayant une fonction horlogère dont les caractéristiques sont énoncées à la revendication 1.

La présente invention a également pour objet un objet portatif ayant une fonction horlogère, telle une pièce d'horlogerie électronique, susceptible d'être mis à l'heure automatiquement dont les caractéristiques sont énoncées à la revendication 4.

Des modes de réalisations avantageux de la présente invention, décrits dans la suite de la présente description, font l'objet des revendication dépendantes.

Selon la présente invention, on transmet ainsi avantageusement, vers l'objet portatif à fonction horlogère, un signal de mise à l'heure ou signal horaire par l'intermédiaire d'ondes acoustiques. Cette solution a pour avantage essentiel de nécessiter des moyens d'émission d'un signal acoustique, tel un haut-parleur, que l'on trouve conventionnellement dans de nombreux équipements électroniques. En particulier, le signal acoustique de mise à l'heure peut être transmis vers l'objet portatif à fonction horlogère par l'intermédiaire du haut-parleur d'un ordinateur personnel, du haut-parleur d'un téléviseur, d'un poste radio ou d'un combiné téléphonique, ou également au moyen d'un autre objet susceptible d'émettre un signal acoustique.

En particulier, selon un mode de réalisation avantageux de la présente invention, l'objet portatif à fonction horlogère, telle une pièce d'horlogerie électronique, comprend un circuit générateur de sons utilisé conventionnellement pour émettre un signal acoustique déterminé, tel un signal acoustique d'alarme, et qui est agencé pour recevoir et convertir un signal acoustique incident porteur d'une information horaire de mise à l'heure en un signal de correction de l'information horaire affichée par ledit objet portatif.

Selon ce mode de réalisation avantageux, l'objet portatif à fonction horlogère est ainsi non seulement susceptible d'être mis à l'heure automatiquement mais peut également, à titre d'amélioration, transmettre un signal acoustique de mise à l'heure à destination d'un autre objet portatif analogue.

Ces objets, caractéristiques et avantages, ainsi que d'autres, de la présente invention apparaîtront plus clairement à la lecture de la description détaillée qui suit, faite en référence aux dessins annexés donnés à titre d'exemples non limitatifs et dans lesquels :
- la figure 1 illustre schématiquement un exemple de réalisation d'un système de mise à l'heure automatique d'un objet portatif ayant une fonction horlogère, telle une pièce d'horlogerie électronique, conforme à la présente invention;
- la figure 2 montre un schéma bloc détaillé d'un exemple non limitatif d'une pièce d'horlogerie pouvant être mise à l'heure automatiquement;
- la figure 3 représente un schéma électrique d'un circuit convertisseur d'un signal acoustique pouvant être utilisé comme moyens de réception du signal acoustique de mise à l'heure;
- la figure 4 représente les niveaux de tension en fonction de temps en deux endroits du circuit de la figure 3 lorsque ce circuit est utilisé comme générateur de sons; et
- la figure 5 représente les niveaux de tension en fonction du temps en deux endroits du circuit de la figure 3 lorsque ce circuit est utilisé comme récepteur du signal acoustique de mise à l'heure.

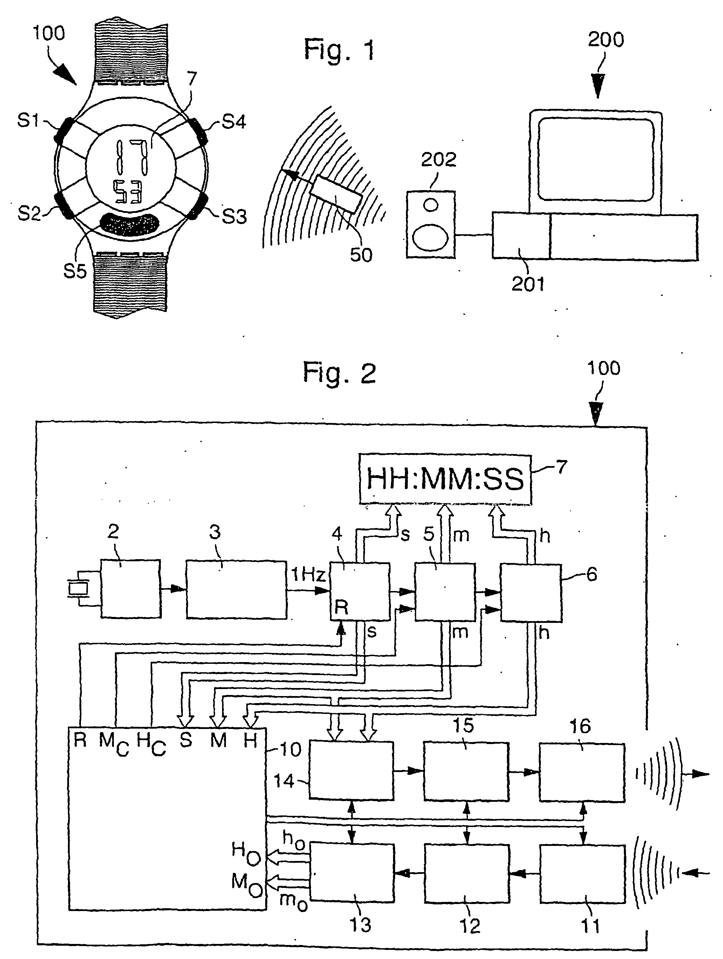

La figure 1 montre schématiquement un système de mise à l'heure automatique d'un objet portatif ayant une fonction horlogère, telle une pièce d'horlogerie électronique désignée dans son ensemble par la référence numérique 100, ce système constituant un mode de réalisation de la présente invention. Ce système comprend en outre, de manière non limitative, un terminal informatique ou ordinateur personnel, désigné par la référence numérique 200.

Conformément à l'invention, l'ordinateur personnel 200 comprend au moins des moyens d'émission d'un signal acoustique de mise à l'heure, ce signal acoustique de mise à l'heure étant schématisé par le bloc portant la référence numérique 50. Dans l'exemple représenté à la figure 1, ces moyens d'émission du signal acoustique de mise à l'heure se présentent sous la forme d'une carte son 201 dont est typiquement équipé l'ordinateur personnel 200 et de un ou plusieurs haut-parleurs 202.

Les moyens d'émission sont indépendants du type d'équipement utilisé. Ainsi, le signal acoustique de mise à l'heure 50 peut alternativement être transmis par le biais d'un haut-parleur d'un téléviseur ou d'un poste radio, notamment afin de permettre une mise à l'heure de l'objet portatif, par exemple lors du passage d'un encart publicitaire sur ce téléviseur ou cet appareil radio. Le signal acoustique de mise à l'heure peut aussi être transmis par le biais d'un haut-parleur d'un combiné téléphonique, notamment afin de permettre une mise à l'heure de l'objet portatif, par exemple suite à l'appel d'un service de mise à l'heure automatique par téléphone.

L'un des avantages de la présente invention réside ainsi dans le fait que l'on utilise avantageusement des moyens déjà typiquement présents pour émettre le signal de mise à l'heure. En effet, il suffit, pour pouvoir mettre l'invention en oeuvre, d'introduire dans l'ordinateur un programme lui permettant de moduler le signal acoustique de façon à ce que ce signal puisse ensuite être convenablement décodé par l'objet portatif 100.

Préférablement, l'ordinateur personnel 200, ou tout autre terminal informatique telle une console de jeu, est connecté sur un réseau informatique étendu, tel internet, de manière à permettre à un utilisateur de se connecter sur un site déterminé, accessible via ce réseau informatique étendu, et fournissant au moins une indication horaire. Ce site peut aisément être agencé de manière à ce qu'il provoque, par exemple suite à une action de l'utilisateur sur le site internet, l'émission, via le haut-parleur 202 de l'ordinateur personnel 200, d'un signal acoustique de mise à l'heure dérivant de l'indication horaire fournie par le site. On peut ainsi avantageusement tirer parti du fait que l'ordinateur personnel 200 est connecté sur ce réseau informatique étendu, tel internet, pour effectuer la mise à l'heure à partir d'une indication horaire fournie par un site intemet déterminé.

Au cas où l'on utiliserait un haut-parleur d'un téléviseur ou d'un poste radio, il conviendra de transmettre le signal acoustique de mise à l'heure convenablement modulé sur un canal télévisuel déterminé, respectivement une station radio déterminée, ce signal acoustique de mise à l'heure étant relayé au porteur de l'objet portatif par l'intermédiaire du haut-parleur du téléviseur, respectivement du poste de radio.

De même, dans le cas d'une mise à l'heure par téléphone, le signal acoustique de mise à l'heure peut parfaitement être transmis convenablement modulé sur la ligne téléphonique et être relayé par le haut-parleur du combiné téléphonique.

La pièce d'horlogerie électronique 100 illustrée à la figure 1 comprend des moyens d'affichage, repérés par la référence numérique 7, tel un affichage à cristaux liquides et des organes de commande, tels des boutons-poussoirs S1 à S5 que l'utilisateur peut actionner à sa guise pour sélectionner des fonctions et/ou modifier des informations ou données de la pièce d'horlogerie, par exemple afin de corriger manuellement l'heure affichée par cette dernière.

Selori la présente invention, la pièce d'horlogerie 100 comporte en outre notamment des moyens de réception, non représentés dans cette figure, agencés pour recevoir un signal acoustique de mise à l'heure 50 émis, par exemple, au moyen du haut-parleur 202 de l'ordinateur personnel de la figure 1.

On notera que ces moyens de réception du signal acoustique de mise à l'heure peuvent être tout type de transducteur électroacoustique susceptible de produire un signal électrique à partir d'un signal acoustique incident. La notion de "transducteur électroacoustique" englobe ainsi aussi bien les transducteurs de type piézo-électrique que les transducteurs de type électrodynamique.

La figure 2 montre, sous forme d'un schéma bloc, un exemple de réalisation de la pièce d'horlogerie électronique 100 de la figure 1. Comme on le voit sur la figure 2, la pièce d'horlogerie, repérée globalement par la référence 100, comprend, en série, un oscillateur à quartz 2, une chaîne de division 3 délivrant un signal à 1 Hz, par exemple, un compteur des secondes 4, un compteur des minutes 5 et un compteur des heures 6. Le compteur des secondes 4 fournit classiquement une impulsion par minutes permettant d'incrémenter le compteur des minutes 5 et le compteur des minutes 5 fournit classiquement une impulsion par heure permettant d'incrémenter le compteur des heures 6. Les compteurs 4, 5 et 6 produisent ainsi respectivement une indication de la seconde s, de la minute m et de l'heure h.

Ces indications de la seconde s, de la minute m et de l'heure h sont délivrées à des moyens d'affichage 7, tel l'affichage à cristaux liquides.déjà mentionné en référence à la figure 1. Ces mêmes indications s, m et h sont par ailleurs délivrées à des moyens électronique de contrôle, repérés généralement par la référence numérique 10. Ces moyens électroniques de contrôle 10 comprennent notamment des entrées, indiquées M et H, connectées respectivement aux compteurs 5 et 6 pour recevoir les indications de la minute m et de l'heure h.

On notera que les moyens électroniques de contrôle peuvent être réalisés sous la forme d'un microcontrôleur ou microprocesseur programmé de manière à lui faire remplir les fonctions énoncées dans la présente description.

Ces moyens électroniques de contrôle 10 comprennent notamment des sorties, indiquées R, Mc et Hc pour délivrer des impulsions de correction permettant de corriger les indications de la seconde s, de lar minute m et de l'heure h des compteurs 4, 5 et 6. respectivement. En particulier, la sortie R des moyens électroniques de contrôle 10 délivre une impulsion de remise à zéro du compteur des secondes 4, et les sorties Me et Hc délivrent respectivement des impulsions de correction du compteur des minutes 5 et du compteur des heures 6.

Les sorties R, Mc et Hc délivrent typiquement ces impulsions de correction aux compteurs 4, 5 et 6 lors d'une mise à l'heure manuelle de la pièce d'horlogerie. A cet effet, la pièce d'horlogerie comporte des moyens de commande, repérés par la référence numérique 8, actionnables de l'extérieur par un utilisateur. Ces moyens de commande 8 englobent notamment les boutons-poussoirs S1 à S5 de la pièce d'horlogerie qui sont représentés sur la figure 1. En réponse à une action sur ces moyens de commande 8, les moyens électroniques de contrôle 10 délivrent ainsi typiquement des impulsions de correction aux compteurs 4, 5 et 6.

Selon la présente invention, la pièce d'horlogerie comporte en outre, en série et activés par les moyens électroniques de contrôle 10, des moyens de réception du signal acoustique de mise à l'heure, repérés par la référence numérique 11, tel un transducteur électroacoustique, des moyens d'amplification 12 permettant d'amplifier le signal électrique produit par les moyens de réception 11 en réponse au signal, acoustique de mise à l'heure et des moyens de démodulation 13 permettant de dériver des indications de mise à l'heure ho et mo à partir du signal acoustique de mise à l'heure. Ces indications de mise à l'heure ho et mo sont délivrées à des entrées Ho et Mo des moyens électroniques de contrôle 10.

Les moyens électroniques de contrôle 10 sont agencés de sorte qu'ils comparent notamment les indications de l'heure h et de la minute m foumies par les compteurs 5 et 6 aux indications de mise à l'heures ho et mo dérivées du signal acoustique de mise à l'heure 50. En réponse à cet comparaison, les moyens électroniques de contrôle 10 délivrent à leur sortie R, Mc et Hc le nombre d'impulsions de correction adéquat pour faire coïncider l'heure de la pièce d'horlogerie avec l'heure transmise au moyen du signal acoustique de mise à l'heure 50.

Préférablement, la pièce d'horlogerie est en outre agencée pour émettre un signal acoustique de mise à l'heure à destination d'une autre pièce d'horlogerie ou objet portatif analogue du système.. La pièce d'horlogerie illustrée à la figure 2 comporte ainsi en outre, préférablement, en série et activés par les moyens électroniques de contrôle 10, des moyens de modulation 14 et des moyens d'entraînement 15 associés à des moyens d'émission d'un signal acoustique de mise à l'heure, indiqués par la référence numérique 16. Les moyens de modulation 14 permettent de produire à leur sortie un signal électrique modulé à partir des indications m et h fournies respectivement par les compteurs des minutes 5 et des heures 6. Les moyens d'entraînement 15 permettent de produire un signal de commande permettant d'attaquer les moyens d'émission 16 en réponse au signal électrique modulé fourni par les moyens de modulation de manière à ce qu'ils émettent, en réponse, un signal acoustique de mise à l'heure.

On notera que les moyens d'émission 16 du signal acoustique de mise à l'heure peuvent être tout type de transducteur électroacoustique susceptible de produire un signal acoustique à partir d'un signal électrique de commande. La notion de "transducteur électroacoustique" englobe ainsi aussi bien les transducteurs de type piézo-électrique que les transducteurs de type électrodynamique.

Ainsi, un avantage de cette variante de la pièce d'horlogerie réside dans le fait qu'un porteur d'une telle pièce d'horlogerie, ou d'un objet portatif analogue ayant une fonction horlogère et répondant aux caractéristiques susmentionnées, peut lui-même transmettre un signal acoustique de mise à l'heure à destination d'un autre porteur d'une telle pièce d'horlogerie. Cette variante permet par exemple à un voyageur équipé d'une telle pièce d'horlogerie, en particulier lorsque ce voyageur change de fuseau horaire, de mettre sa montre à l'heure par l'intermédiaire d'une autre pièce d'horlogerie analogue dont serait équipée une personne vivant dans ce fuseau horaire.

A titre de simplification de la pièce d'horlogerie illustrée à la figure 2, les moyens de réception 11 et d'émission 16 du signal acoustique de mise à l'heure peuvent utiliser un seul et même transducteur électroacoustique qui fonctionne de manière réversible.

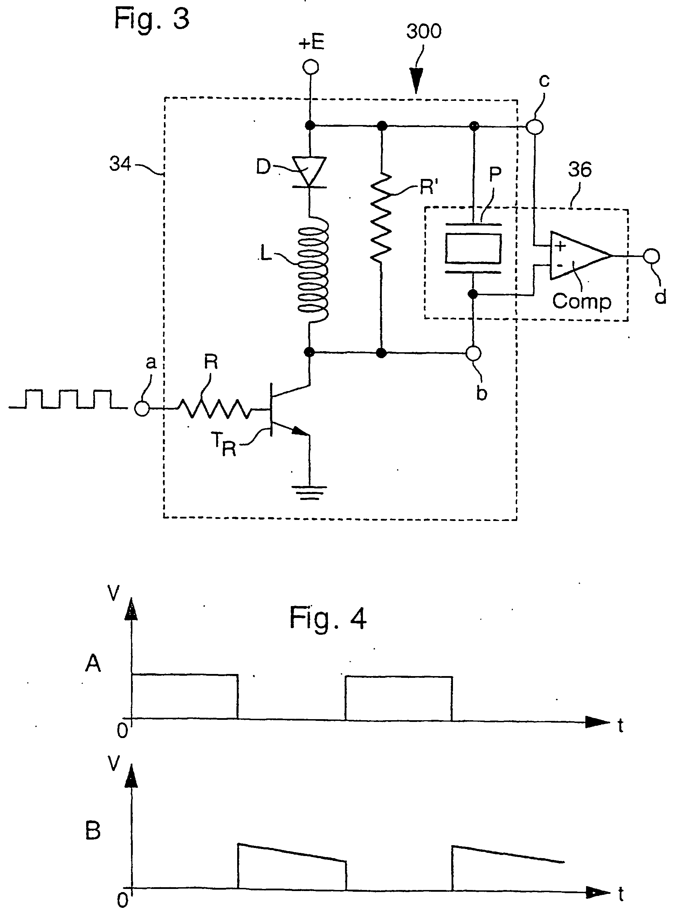

A titre de variante particulièrement avantageuse, la pièce d'horlogerie est équipée d'un circuit générateur de sons agencé de manière à pouvoir en outre recevoir le signal acoustique de mise à l'heure. La demande de brevet européen enregistrée sous le numéro 99115319.8, également au nom de la Demanderesse, et pour laquelle une priorité est revendiquée dans le cadre de la présente invention, décrit par exemple l'utilisation d'un circuit générateur de sons comprenant un vibreur piézo-électrique comme récepteur d'un signal acoustique. Cette demande de brevet européen, incorporée ici par référence, décrit en particulier un convertisseur électronique dont une illustration est présentée à la figure 3.

La figure 3 montre ainsi un circuit générateur de sons comprenant un convertisseur électronique désigné dans son ensemble par la référence numérique 300. Comme il ressort de cette figure, le convertisseur électronique 300 susmentionné est constitué par l'association d'un circuit d'entraînement 34, d'un vibreur piézo-électrique P et d'un circuit de comparaison 36 dont les principes de fonctionnement respectifs vont être décrits ci-dessous.

Le circuit d'entraînement 34 du vibreur piézo-électrique P comprend une branche de circuit dans laquelle une bobine L et une diode D sont montées en série, une résistance R' et le vibreur piézo-électrique P étant branchés en parallèle sur cette branche de circuit.

Le circuit d'entraînement 34 reçoit sur une borne d'entrée "a" un signal impulsionnel de commande à créneaux comme cela est représenté par la courbe A de la figure 4. Ce signal de commande est appliqué à travers une résistance R à la base d'un transistor T_{R}. Lorsque le transistor T_{R} est rendu conducteur par une impulsion de commande, la bobine L est parcourue par un courant fourni par une tension d'alimentation +E, tandis que le point de connexion "b" du vibreur piézo-électrique P est relié à la masse du circuit d'entraînement 34. Lorsque le transistor T_{R.} passe à l'état bloqué lors du front descendant de chaque impulsion de commande, toute l'énergie accumulée dans la bobine L est transmise aux bornes du vibreur P, chargeant celui-ci à une tension déterminée (courbe B de la figure 4) supérieure à la tension d'alimentation +E. Lorsqu'à son tour, le vibreur P commence à se décharger, la diode. D bloque le retour du courant.. On notera qu'entre deux signaux impulsionnels de commande successifs, le vibreur piézo-électrique P peut tout de même se décharger partiellement à travers la résistance R'. Ainsi, lorsque plus aucun signal de commande n'est appliqué au transistor T_{R} et que celui-ci se trouve donc à l'état bloqué, la tension aux bornes du vibreur P retrouve progressivement sa valeur de repos.

Le circuit de comparaison 36 comprend des moyens de comparaison constitués par un comparateur analogique-digital COMP. L'une des entrées du comparateur COMP est reliée à un point de connexion "c" de la tension d'alimentation continué +E, tandis que l'autre entrée dudit comparateur COMP est reliée au point de sortie "b" du circuit d'entraînement 34, autrement dit au point de connexion entre le vibreur piézo-électrique P est le transistor T_{R}. Comme déjà précisé ci-dessus, en l'absence de signal de commande appliqué sur la base du transistor T_{R}, le vibreur P est au repos et la tension à ses bornes est égale à la tension d'alimentation +E. Dans ces conditions, le vibreur piézo-électrique P n'est plus employé comme générateur de sons mais peut, au contraire, être employé comme récepteur d'un signal acoustique, et en particulier du signal acoustique de mise à l'heure selon la présente invention.

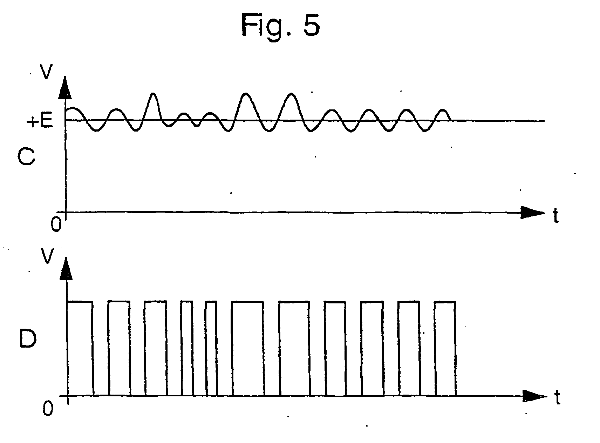

Ainsi, sous l'effet d'un signal acoustique incident, telle signal acoustique de mise à l'heure, la tension aux bornes du vibreur P va se mettre à osciller de part et d'autre de sa tension de repos +E comme le montre la courbe C de la figure 5. Le comparateur COMP compare ensuite la tension produite par le vibreur P avec sa tension de référence qui est la tension d'alimentation +E du circuit d'entraînement 34. A chaque fois que la tension produite par le vibreur piézo-électrique excède la tension de référence +E, le comparateur COMP va produire un signal impulsionnel à sa sortie "d" (courbe D de la figure 5). Il est ainsi possible de transformer un signal acoustique incident en un signal électrique modulé, ici un signal électrique modulé en fréquence, et dériver de ce signal électrique, notamment les indications horaires ho et mo mentionnées en référence à la figure 2.

On comprendra que différentes modifications et/ou adaptations peuvent être apportées aux modes de réalisations décrits dans la présente description sans toutefois sortir du cadre de l'invention défini par les revendications annexées.

## Revendications

1. Système permettant la mise à l'heure automatique d'au moins un objet portatif (100) ayant une fonction horlogère, ce système comprenant au moins des moyens d'émission (201, 202) d'un signal acoustique de mise à l'heure (50) destiné à corriger une indication horaire dudit objet portatif (100), cet objet portatif (100) comportant des moyens de réception (11) dudit signal acoustique de mise à l'heure (50) et des moyens (12, 13) permettant de dériver de ce signal acoustique de mise à l'heure (50) des indications de mise à l'heure (ho, mo) permettant de corriger ladite indication horaire de l'objet portatif (100),
**caractérisé en ce que** ledit objet portatif (100) est en outre agencé pour émettre un signal acoustique de mise à l'heure (50), cet objet portatif (100) comprenant des moyens d'émission (16) d'un signal acoustique de mise à l'heure (50).

2. Système selon la revendication 1, **caractérisé en ce que** ledit objet portatif (100) comporte un circuit générateur de sons (300) agencé notamment pour émettre un signal acoustique d'alarme, ce circuit générateur de sons (300) formant également lesdits moyens de réception (11) et d'émission (16) du signal acoustique de mise à l'heure (50).

3. Système selon la revendication 2, **caractérisé en ce que** ledit circuit générateur de sons (300) comprend un vibreur piézo-électrique (P) formant un émetteur-récepteur d'ondes acoustiques et des moyens de commutation (T_{R}) agencés pour s'enclencher et se déclencher sur réception d'un signal impulsionnel de commande, ainsi qu'une branche de circuit dans laquelle une bobine (L) et une diode (D) sont montées en série avec lesdits moyens de commutation (T_{R}), une résistance (R') et ledit vibreur piézo-électrique (P) étant connecté, en parallèle avec ladite bobine (L) et ladite diode (D), en série avec lesdits moyens de commutation (T_{R}),
ledit circuit générateur de son (300) comprenant par ailleurs des moyens de comparaison (36, COMP) pour comparer la tension aux bornes dudit vibreur piézo-électrique (P) avec une tension de référence (+E) lors de la réception d'un signal acoustique de mise à l'heure (50).

4. Système selon la revendication 1, **caractérisé en ce que** ce système comporte un ordinateur personnel (200), un téléviseur, un poste de radio ou un combiné téléphonique comprenant un haut-parleur (202) formant lesdits moyens d'émission du signal acoustique de mise à l'heure (50).

5. Système selon la revendication 2, comportant ledit ordinateur personnel (200) comprenant un haut-parleur (202) formant lesdits moyens d'émission du signal acoustique de mise à l'heure (50), **caractérisée en ce que** ledit ordinateur personnel est connecté sur un réseau informatique étendu, tel internet, et **en ce que** le signal acoustique de mise à l'heure (50) est dérivé d'une indication horaire fournie par un site déterminé accessible via ledit réseau informatique étendu.

6. Objet portatif (100) ayant une fonction horlogère susceptible d'être mis à l'heure automatiquement comportant des moyens de réception (11) d'un signal acoustique de mise à l'heure (50) et des moyens (12, 13) permettant de dériver de ce signal acoustique de mise à l'heure (50) des indications de mise à l'heure (ho, mo) permettant de corriger une indication horaire de l'objet portatif (100),
**caractérisé en ce que** cet objet portatif (100) est en outre agencé pour émettre un signal acoustique de mise à l'heure (50) et **en ce qu'**il comprend des moyens d'émission (11) de ce signal acoustique de mise à l'heure (50).

7. Objet portatif selon la revendication 6, **caractérisé en ce que** celui-ci comporte en outre un circuit générateur de sons (300) agencé notamment pour émettre un signal acoustique d'alarme, ce circuit générateur de sons (300) formant également lesdits moyens de réception (11) et d'émission (16) du signal acoustique de mise à l'heure (50).

8. Objet portatif selon la revendication 7, **caractérisé en ce que** ledit circuit générateur de sons (300) comprend un vibreur piézo-électrique (P) formant un récepteur d'ondes acoustiques et des moyens de commutation (T_{R}) agencés pour s'enclencher et se déclencher sur réception d'un signal impulsionnel de commande ainsi qu'une branche de circuit dans laquelle une bobine (L) et une diode (D) sont montées en série avec lesdits moyens de commutation (T_{R}), une résistance (R') et ledit vibreur piézo-électrique (P) étant connecté, en parallèle avec ladite bobine (L) et ladite diode (D), en série avec lesdits moyens de commutation (T_{R}),
ledit circuit générateur de son (300) comprenant par ailleurs des moyens de comparaison (36, COMP) pour comparer la tension aux bornes dudit vibreur piézo-électrique (P) avec une tension de référence (+E) lors de la réception d'un signal acoustique de mise à l'heure (50).

9. Objet portatif selon la revendication 8, **caractérisé en ce que** lesdits moyens de commutation (T_{R}) comprennent un transistor.

## Patentansprüche

1. System, das die automatische Zeiteinstellung wenigstens eines tragbaren Gegenstandes (100), der eine Zeitmessfunktion besitzt, ermöglicht, wobei dieses System wenigstens Mittel (201, 202) zum Senden eines akustischen Zeiteinstellsignals (50) umfasst, das dazu bestimmt ist, eine Zeitangabe des tragbaren Gegenstandes (100) zu korrigieren, wobei dieser tragbare Gegenstand (100) Mittel (11), die das akustische Zeiteinstellsignal (50) empfangen, und Mittel (12, 13), die ermöglichen, aus diesem akustischen Zeiteinstellsignal (50) Zeiteinstellangaben (ho, mo) abzuleiten, die die Korrektur der Zeitangabe des tragbaren Gegenstandes (100) ermöglichen, umfasst,
**dadurch gekennzeichnet, dass** der tragbare Gegenstand (100) außerdem so beschaffen ist, dass er ein akustisches Zeiteinstellsignal (50) aussendet, wobei dieser tragbare Gegenstand (100) Mittel (16) zum Senden eines akustischen Zeiteinstellsignals (50) umfasst.

2. System nach Anspruch 1, **dadurch gekennzeichnet, dass** der tragbare Gegenstand (100) eine Tongeneratorschaltung (300) umfasst, die insbesondere so beschaffen ist, dass sie ein akustisches Alarmsignal aussendet, und außerdem die Mittel (11) zum Empfangen des akustischen Zeiteinstellsignals (50) und die Mittel (16) zum Aussenden des akustischen Zeiteinstellsignals (50) bildet.

3. System nach Anspruch 2, **dadurch gekennzeichnet, dass** die Tongeneratorschaltung (300) einen piezoelektrischen Vibrator (P), der einen Schallwellen-Sender/Empfänger bildet, Umschaltmittel (T_{R}), die so beschaffen sind, dass sie bei Empfang eines Steuerimpulssignals schließen und öffnen, und einen Schaltungszweig, in dem eine Spule (L) und eine Diode (D) mit den Umschaltmittein (T_{R}) in Reihe geschaltet sind, umfasst, wobei ein ohmscher Widerstand (R') und der piezoelektrische Vibrator (P) parallel zu der Spule (L) und der Diode (D) mit den Umschaftmittein (T_{R}) in Reihe geschaltet sind,
wobei die Tongeneratorschaltung (300) außerdem Vergleichsmittel (36, COMP) umfasst, um die Spannung an den Anschlüssen des piezoelektrischen Vibrators (P) mit einer Referenzspannung (+E) zu vergleichen, wenn sie ein akustisches Zeiteinstellsignal (50) empfängt.

4. System nach Anspruch 1, **dadurch gekennzeichnet, dass** dieses System einen Personalcomputer (200), ein Fernsehgerät, eine Funkstation oder einen Telephonhörer mit einem Lautsprecher (202), der die Mittel zum Aussenden des akustischen Zeiteinstellsignals (50) bildet, umfasst.

5. System nach Anspruch 2, das den Personalcomputer (200) umfasst, der einen Lautsprecher (202) aufweist, der die Mittel zum Aussenden des akustischen Zeiteinstellsignals (50) bildet, **dadurch gekennzeichnet, dass** der Personalcomputer mit einem Weitbereichsnetz wie etwa dem Internet verbunden ist und dass das akustische Zeiteinstellsignal (50) aus einer Zeitangabe abgeleitet wird, die von einem bestimmten Site geliefert wird, auf das über das Weitbereichsnetz zugegriffen werden kann.

6. Tragbarer Gegenstand (100), der eine Zeitmessfunktion besitzt, die automatisch eingestellt werden kann, und Mittel (11), die ein akustisches Zeiteinstellsignal (50) empfangen, sowie Mittel (12, 13), die ermöglichen, aus diesem akustischen Zeiteinstellsignal (50) Angaben (ho, mo) zur Zeiteinstellung abzuleiten, die ermöglichen, eine Zeitangabe des tragbaren Gegenstandes (100) zu korrigieren, umfasst,
**dadurch gekennzeichnet, dass** dieser tragbare Gegenstand (100) außerdem so beschaffen ist, dass er ein akustisches Zeiteinstellsignal (50) aussendet, und dass er Mittel (11) zum Aussenden dieses akustischen Zeiteinstellsignals (50) umfasst.

7. Tragbarer Gegenstand nach Anspruch 6, **dadurch gekennzeichnet, dass** er außerdem eine Tongeneratorschaltung (300) aufweist, die insbesondere so beschaffen ist, dass sie ein akustisches Alarmsignal aussendet, und außerdem die Mittel (11) zum Empfangen des akustischen Zeiteinstellsignals (50) und die Mittel (16) zum Aussenden des akustischen Zeiteinstellsignals (50) bildet.

8. Tragbarer Gegenstand nach Anspruch 7, **dadurch gekennzeichnet, dass** die Tongeneratorschaltung (300) einen piezoelektrischen Vibrator (P), der einen Schallwellenempfänger bildet, Umschaltmittel (T_{R}), die so beschaffen sind, dass sie bei Empfang eines Steuerimpulssignals schließen und öffnen, und einen Schaltungszweig, in dem eine Spule (L) und eine Diode (D) mit den Umschaltmitteln (T_{R}) in Reihe geschaltet sind, umfasst, wobei ein ohmscher Widerstand (R') und der piezoelektrische Vibrator (P) parallel zu der Spule (L) und der Diode (D) mit den Umschaltmitteln (T_{R}) in Reihe geschaltet sind,
wobei die Tongeneratorschaltung (300) außerdem Vergleichsmittel (36, COMP) umfasst, um die Spannung an den Anschlüssen des piezoelektrischen Vibrators (P) mit einer Referenzspannung (+E) zu vergleichen, wenn sie ein akustisches Zeiteinstellsignal (50) empfängt.

9. Tragbarer Gegenstand nach Anspruch 8, **dadurch gekennzeichnet, dass** die Umschaltmittel (T_{R}) einen Transistor enthalten.

## Claims

1. System allowing the time-setting of at least a portable object (100) having an horological function, this system including at least means (201, 202) for transmitting an acoustic time-setting signal (50) for correcting a time indication of said portable object (100), this portable object (100) including means (11) for receiving said acoustic time-setting signal (50) and means (12, 13) for deriving time-setting indications (ho, mo) from said acoustic time-setting signal (50) allowing said time indication of said portable object (100) to be corrected,
**characterised in that** said portable object (100) is further adapted to transmit an acoustic time-setting signal (50), this portable object (100) including means (16) for transmitting an acoustic time-setting signal (50).

2. System according to claim 1, **characterised in that** said portable object (100) includes a sound generator circuit (300) in particular for generating an acoustic alarm signal, this sound generator circuit (300) also forming said means for receiving (11) and transmitting (16) the acoustic time-setting signal (50).

3. System according to claim 2, **characterised in that** said sound generator circuit (300) includes a piezoelectric vibrator (P) forming an acoustic wave transceiver and switching means (T_{R}) arranged to switch on and off upon reception of a pulse control signal, and a circuit branch in which a coil (L) and a diode (D) are connected in series with said switching means (T_{R}), a resistor (R') and said piezoelectric vibrator (P) being connected, in parallel with said coil (L) and said diode (D), in series with said switching means (T_{R}),
said sound generator circuit (300) further including comparing means (36, COMP) for comparing the voltage across the terminals of said piezoelectric vibrator (P) with a reference voltage (+E) when an acoustic time-setting signal (50) is received.

4. System according to claim 1, **characterised in that** this system includes a personal computer (200), a television, a radio or a telephone receiver including a loud speaker (202) forming said transmission means for the acoustic time-setting signal (50).

5. System according to claim 2, including said personal computer (200) including a loud speaker (202) forming said transmission means for the acoustic time-setting signal (50), **characterised in that** said personal computer is connected to a wide area computer network, such as the internet, and **in that** the acoustic time-setting signal (50) is derived from a time indication provided by a determined site accessible via said wide area computer network.

6. Portable object (100) having an horological function capable of being automatically set to the right time including means for receiving (11) an acoustic time-setting signal (50) and means (12, 13) for deriving time-setting indications (ho, mo) from said acoustic time-setting signal (50) allowing a time indication of the portable object to be corrected,
**characterised in that** said portable object (100) is further adapted to transmit an acoustic time-setting signal (50) and **in that** it includes transmission means (11) for said acoustic time-setting signal (50).

7. Portable object according to claim 6, **characterised in that** it further includes a sound generator circuit (300) in particular for generating an acoustic alarm signal, this sound generator circuit (300) also forming said receiving (11) and transmission (16) means for said acoustic time-setting signal (50).

8. Portable object according to claim 7, **characterised in that** said sound generator circuit (300) includes a piezoelectric vibrator (P) forming an acoustic wave receiver and switching means (T_{R}) arranged for switching on and off upon reception of a pulse control signal, and a circuit branch in which a coil (L) and a diode (D) are mounted in series with said switching means (T_{R}), a resistor (R') and said piezoelectric vibrator (P) being connected, in parallel with said coil (L) and said diode (D), in series with said switching means (T_{R}),
said sound generator circuit (300) further including comparing means (36, COMP) for comparing the voltage across the terminals of said piezoelectric vibrator (P) with a reference voltage (+E) when an acoustic time-setting signal (50) is received.

9. Portable object according to claim 8, **characterised in that** said switching means (T_{R}) include a transistor.
